# EUROPEAN PATENT SPECIFICATION

(11) **EP 3 454 424 B1**
(45) Date of publication and mention of the grant of the patent: **18.06.2025**
(21) Application number: 18191679.2
(22) Date of filing: 30.08.2018
(51) Int. Cl.: H01R 4/70, H01R 4/72

(54) **ARRANGEMENT COMPRISING A CABLE CONNECTOR, A COVER AND A FASTENER**
ANORDNUNG MIT EINEM KABELVERBINDER, EINER ABDECKUNG UND EINEM BEFESTIGUNGSELEMENT
DISPOSITIF COMPRENANT UN CONNECTEUR DE CÂBLE, UN COUVERCLE ET UNE ATTACHE

(30) Priority: 07.09.2017 FI 20175796
(43) Date of publication of application: 13.03.2019
(73) Proprietor: Ensto Oy, 06101 Porvoo (FI)
(72) Inventor: Mariani, Marco, 20100 Milano (IT); Kenkkilä, Hannele, 04200 Kerava (FI); Aarnio, Anssi, 06150 Porvoo (FI); Alkila, Kauko, 05460 Hyvinkää (FI)
(74) Representative: Papula Oy

(56) References cited:
- WO-A1-2016/162377
- JP-U- H0 463 567
- US-A- 3 980 374
- US-A1- 2003 236 020
- US-A1- 2017 229 789

## Description

### FIELD

The present disclosure relates to an arrangement comprising a cable connector, a cover and a fastener adapted for clamping a cable to the cable connector.

In particular, the disclosure relates to an arrangement also with a cover for the cable connector, which may be used for low and medium voltage power lines.

### BACKGROUND

Cable connectors are used to join cables to other cables, for example by cable splicing, or to terminal bodies. By securing the cables within the connector by fasteners such as screws or bolts, the requirement for additional fastening devices in assembling the connection may be disposed of.

A particular type of cable connectors, which may be used for low and/or medium voltage lines, is one that is adapted for installations where long-term durability is important and there is no need to repeatedly screw and unscrew the connectors, such as connections of underground cables. These cable connectors can be adapted for fasteners such as shearing screws which clamp the cable to the cable connector so that an electric connection is formed within the cable connector. For this purpose, the cable connector itself can be conductive to so that the electric current from the cable can be conducted through the connector.

It is a common problem that the ends of the fasteners may extend outward from the surface of the connector, even in the case when shearing screws or bolts which break upon installation are used. This may cause both mechanical abrasion from the edges of the fasteners and concentration or peaks in the electric field in the region of the connector. In particular, cable connectors can be used with protecting sleeves such as cold shrink sleeves or heat shrink sleeves, which may easily be damaged by the fasteners, e.g. from the sheared end of a shearing screw or bolt.

The problem has been addressed by hammering the edges of the fasteners so that they align with connector body and by lining the fastener ends with mass.

For example, US 3980374 A discloses a separable splice connector which is particularly suitable for 15/25 kV, 600 ampere primary distribution system cables. WO 2016/162377 A1 discloses color coding accessories for cables and connectors. US 2003/0236020 discloses a field installable, field adjustable angled boot for multi-conductor cables. US 2017/0229789 discloses a connector for the connection of two electrical conductors. JPH 0463567 U discloses a protective cap for terminals.

### SUMMARY

An objective is to eliminate at least some of the drawbacks pertaining to the solutions referred to above. In particular, an objective is to disclose an arrangement with a cover for a cable connector which may be used to smoothen mechanical and/or electrical disturbances resulting from the fasteners of a cable connector. These objectives are solved according to the invention by the arrangement of claim 1. Further advantageous developments of the invention appear from the dependent claims.

By cable, it is meant here an elongated electrical conductor, which may be a transmission line in an electric power network. The cable connector is a device suitable for connecting one or more cables to each other or to an external body. For example, the cable connector may be a connector comprising two or more inlets for connecting cables to each other, for example spliced cables. The cables may be uncovered at the end entering the cable connector, so that they are exposed for direct galvanic contact. Word "inlet" has been used here as the inlets provide access in to the connector body, but it is acknowledged that, for example, the word "outlet" may be used interchangeably as the inlets also provide an exit point for the cables. The cable connector may also be a cable lug or a cable shoe (hereinafter "cable lug") for acting as a terminal connection for at least one cable, the cable lug having one or more inlets for cables. As the cable lug functions as a terminal connection for a cable, the cable connector may only connect the cable to external bodies and the cable remains electrically disconnected from any other cables within the cable connector.

By fasteners, it is meant here fastening elements, such as screws or bolts, suitable for fastening the cable to the connector, for example by clamping the cable to the connector. The fasteners may be shearing screws (which can also be referred as "shearing bolts" etc.) adapted for a portion of their screw body to be sheared off upon installation. The fasteners may be threaded. The connector comprises at least one hole or bore for a fastener, which may also be threaded and which are hereinafter referred to as "screw holes".

The cover as disclosed may be used for cable connectors in electrical grids, e.g. low-voltage and/or middle voltage transmission lines. This may involve, for example, voltages of 1-36 kV. The screws required for this purpose are typically very strong, metallic screws having diameters of one or more centimeters, for example around two centimeters. Consequently, the force required to install them is also notable. The cover may be installed under a sleeve such as a cold-shrink sleeve or a heat-shrink sleeve. In this way, the cover is used between the cable connector and the sleeve so that it can protect the latter from damage.

According to the invention, an arrangement comprises a cover, a cable connector and a fastener adapted for clamping a cable to the cable connector.

The cable connector is a cable lug or a connector comprising two or more inlets for connecting cables to each other. It comprises a cylindrical body having at least one screw hole for a fastener, the at least one screw hole extending transversely with respect to the longitudinal direction of the cylindrical body. The cover is made of a flexible material and comprises a first edge, a second edge, a longitudinal axis extending between the first edge and the second edge, an inner surface for engaging the cable connector, and an outer surface opposite to the inner surface. The cover has a cross section substantially corresponding to a circular arc in a plane perpendicular to the longitudinal axis and extending along the whole length of the cover. The cover is adapted for snap-on attachment to the cylindrical body by a force exerted on the outer surface in a direction perpendicular to the longitudinal axis. This is effected by using flexible material in the cover and it allows the snap-on attachment to take hold quickly and easily. The length of the circular arc is more than 50 percent of the circumference of a full circle allowing sides of the cover corresponding to the circular arc to effect the snap-on attachment. This allows the sides of the cover corresponding to the circular arc to effect the snap-on attachment as an alternative to, for example, only effecting the attachment by one or more projections extending into one or more screw holes of the cable connector. The sides effecting the attachment may extend all the way along the length of the longitudinal axis to form a continuous gripping surface on the opposite sides of the cable connector. The sides may also form more than one continuous gripping surface on each of the opposite sides of the cable connector, for example forked gripping surfaces. The solution allows screw holes in the cable connector to be covered and the cover to be easily and quickly installed without additional tools or materials such as sealing or adhering materials.

In a further implementation form, the length of the circular arc is less than 95 percent of the circumference of a full circle. Reducing the length of the circular arc from 100 percent of the circumference allows simplifying the snap-on attachment of the cover. For example, the force exerted to effect the snap-on attachment may thus be prevented to bend or damage the cover.

In a further implementation form, the cover comprises at least one region of reduced thickness for alignment with at least one edge of a screw hole in the cable connector. This allows fitting the cover tightly against the cable connector thus preventing ingress of dust, particles or water between the cover and the connector. It may also improve the attachment of the cover to the connector by increasing friction as the contact becomes more tight-packed. In a yet further implementation form, the at least one region of reduced thickness is ring-shaped. This allows tight packing with fasteners having circularly-shaped ends.

In a further implementation form the cover comprises at least one recess extending from the inner surface for alignment with at least one screw hole in the cable connector. This allows accommodating fastener ends extending from the screw holes of the cable connector within the cover so that the contact between the cover and the cable connector becomes more tight-packed.

In a further implementation form, the cover comprises at least one bulge extending from the outer surface for alignment with at least one screw hole in the cable connector. With such a bulge, a recess may be created extending from the inner surface to accommodate a fastener end while maintaining the thickness of the cover constant for the region adapted for alignment with the screw hole and the region around the screw hole. This allows simplifying the manufacturing process and saving material.

In a further implementation form, the cover comprises at least one protrusion extending from the inner surface for engaging a screw hole in the cable connector or a hole in a fastener located in a screw hole in the cable connector. These protrusions allow positioning the cover with respect to the fasteners to speed up and simplify installation. The protrusions may be used for preventing the cover to move in one or more directions with respect to the cable connector. For example, they may prevent the cover from rotating around the longitudinal axis of the cable connector or moving in the longitudinal direction of the cable connector. The protrusions may, additionally, be adapted to effect, at least partially, snap-on attachment of the cover to the cable connector. In a yet further implementation form, the at least one protrusion is adapted to abut against an edge of the screw hole or an edge of a hole in a fastener located in the screw hole. This may further aid in positioning and/or attaching the cover by creating friction between the edge and the protrusion.

In a further implementation form, the cover comprises or is made of material conducting electricity. This allows the cover to smoothen the electric fields that may otherwise concentrate due to sharp features of the fasteners.

In a further implementation form, the cover is semiconducting. In a yet further implementation form, the cover is made of semiconducting plastic. This allows the cover itself to function as a conductor to flatten out any peaks of electricity. By using semiconducting plastic, the cover may be made light, flexible and it may be manufactured efficiently.

In a further implementation form, the cover is symmetric with respect to a rotation of 180 degrees about an axis perpendicular to the longitudinal axis. The symmetric shape may include the surfaces of the cover. It may also include any recesses or bulges therein. The symmetric shape facilitates ease of installation as the cover may be attached to the cable connector either the first edge or the second edge facing front.

The cover may be removably attachable to the cable connector. It may also be fixedly attached to the cable connector, for example along an edge or through an extension.

It is to be understood that the aspects and embodiments of the invention described above may be used in any combination with each other. Several of the aspects and embodiments may be combined together to form a further embodiment of the invention.

### LIST OF FIGURES

The accompanying drawings, which are included to provide a further understanding of the invention and constitute a part of this specification, illustrate embodiments of the invention and together with the description help to explain the principles of the invention. In the drawings:
Fig. 1 illustrates a cable connector.
Fig. 2 illustrates a cover for a cable connector.
Fig. 3a illustrates a cable connector and a cover.
Fig. 3b illustrates a cable connector and a cover in a partially cross-sectional view.
Figs. 4a-c illustrate protrusions in a cover for a cable connector.

Like references are used to designate equivalent or at least functionally equivalent parts in the accompanying drawings.

### DETAILED DESCRIPTION

The detailed description provided below in connection with the appended drawings is intended as a description of the embodiments and is not intended to represent the only forms in which the embodiment may be constructed or utilized. However, the same or equivalent functions and structures may be accomplished by different embodiments.

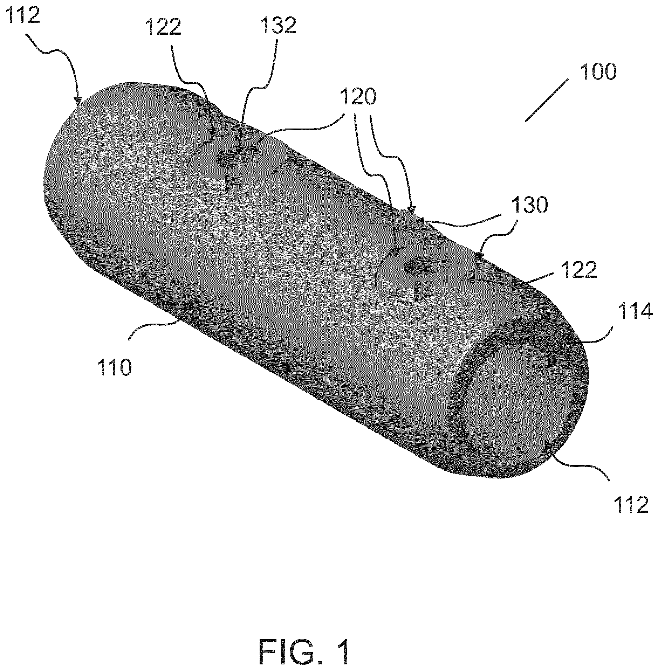

Fig. 1 illustrates a cable connector 100 (below, referred to as "connector"). The connector 100 has a body 110, the surface of which may be curved. The surface may also be smooth. The body 110 may be substantially cylindrical to allow convenient accommodation of cylindrical cables. The body 110 comprises one or more inlets 112 for cables, for example one or more inlet 112 when the connector 100 is a cable lug or two or more inlets when the connector 100 is adapted for connecting two cables together. The inlets 112 may be circular openings. The body 110 comprises a bore, which may be cylindrical, for accommodating one or more cables. The bore may be an open bore but it may also be a closed bore, for example when the connector 100 is a cable lug. The bore may comprise threads or grooves 114 along the whole or partial length of the bore. The threads or grooves 114 may be adapted to form contact interfaces for transmitting electric current from a cable placed inside the connector into the body 110. Threads 114 may also be included for attaching the connector 100 to external bodies, for example to a collar or a flange. The diameter of the body 110, in the plane perpendicular to the longitudinal direction, may be, for example, 1-10 centimeters. The length of the body 110 may be, for example, 1-30 centimeters. The body 110 or the whole connector 100 may be made of rigid material. In particular, the body 110 or the connector 100 may be made of metal.

The connector 100 comprises one or more screw holes 120 (pictured here with fasteners 130 within) in the body 110. The number of holes may be, for example, from one to ten. For example, the number may be one for a cable lug, or two or four for a connector suitable for two cables. The holes 120 may be cylindrical. The holes 120 have edges 122, which may be substantially circular or oval or, in particular when the surface of the body 110 is curved, whose planar projection may be circular or oval. The holes 120 may extend transversely with respect to the longitudinal direction of the body 110. For example, the holes 120 may extend radially towards the central axis of the body 110. The holes 120 may, for example, be positioned in a single line or in two lines (the latter alternative pictured). The holes 120 may comprise threads for the fasteners 130. When the fasteners 130 are installed in the connector 100, the fasteners 130 or their edges may extend above the surface of the body 110, in particular when the surface of the body 110 is curved. A fastener 130 may, in turn, comprise a hole 132 in the longitudinal direction. Such holes 132 may be cylindrical. They may also be tapered or comprise a tapered portion. The holes 132 may be open bores, i.e. through-holes, or closed bores.

A cable may be a single-wire conductor or a multi-wire conductor. It may comprise or be made of metal, for example of aluminum or copper. The fasteners 130 is adapted for clamping the cable to the connector 100. The fasteners 130 may be screws or bolts, for example shearing screws or shearing bolts, which break upon installation. The fasteners 130 may be made of electrically conductive material, for example metal.

Even though the connector 100 has been illustrated in Fig. 1 to comprise two inlets 112, the number and/or positioning of the inlets 112 may also differ. For example, the connector 100 may comprise two or more inlets positioned perpendicularly with respect to each other in a transverse dimension of the connector 100.

In an embodiment, the body 110 is joined with a second body to form a cable connector, the combination which may form a monolithic body. For example, the body 110 may be joined with an extension providing an attachment point through which the connector 100 may be attached to an external object. In particular, an attachment point may be included when the connector 100 is a cable lug.

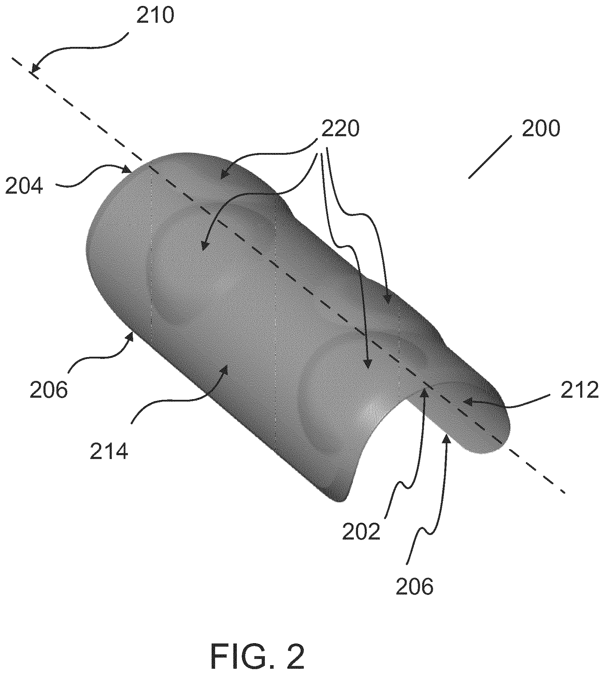

Fig. 2 illustrates a cover 200. The cover 200 is adapted for locking to a cylindrical object, which may have holes extending transversely to its longitudinal direction. The cylindrical object may also have a smooth outer surface. In particular, the cylindrical object may be any type of connector 100 described in the present disclosure.

The cover 200 has a first edge 202, a second edge 204 and a longitudinal axis 210 extending between the edges. The longitudinal axis 210 may extend all the way from the first edge 202 to the second edge 204. It may also intersect the midpoint of the first edge 202, the second edge 204 or them both. At least one of the first edge 202 and the second edge 204 may be perpendicular to the longitudinal axis 210 at the point of intersection of the edge 202, 204 and the axis 210. At least one of the first edge 202 and the second edge 204 may be curved, for example having the shape of a circular arc. Various alternative shapes are possible as well. In addition, the cover 200 may comprise one or more additional edges 206 such as side edges. In the example of Fig. 2, an example having two side edges 206 is illustrated. The additional edges 206 may be straight or substantially straight lines. The additional edges 206 may be parallel to the longitudinal axis 210. A gripping surface created by the cover 200 may be controlled by the shape of the edges 202, 204, 206.

The cover 200 comprises an inner surface 212 and an outer surface 214, the former being located on the opposite side of the cover 200 with respect to the latter. The inner surface 212 has been adapted for engaging the connector 100. In particular, the inner surface may be shaped to follow the surface of the body 110 of the connector 100. The shape of the inner surface 212 may be adapted for locking the cover 200 to the connector 100 at least in the dimensions perpendicular to the longitudinal axis 210 and optionally also in the direction of the longitudinal axis 210. The longitudinal axis 210 may be as being parallel to the inner surface 212 or the outer surface 214. It may be further defined to be positioned on the inner surface 212 or the outer surface 214. The longitudinal axis 210 may be located substantially on the center of the inner surface 212 or the outer surface 214. At least one of the inner surface 212 and the outer surface 214 may be symmetric with respect to the longitudinal axis 210, as illustrated in Fig. 2. Consequently, the cover 200 may be symmetric with respect to the longitudinal axis 210. At least the inner surface 212 may be curved in the direction perpendicular to the longitudinal axis 210. This allows the cover 200 to follow the shape of the connector 100. For this purpose, the inner surface 212 may be concave. The outer surface 214 may be convex. As in the example illustrated in Fig. 2, the whole cover 200 may be curved in the direction perpendicular to the longitudinal axis 210. The cover 200 may be shaped substantially as a curved rectangle, as illustrated, a shape which may be easily manufactured and which is resistant to breaking as the number of fragile features may be limited. Also other shapes are possible, for example an oval shape or a circular shape. Any corners in the shape may be rounded to avoid mechanical abrasion and/or build-up of electromagnetic fields. The inner surface 212 may be adapted for adhesive attachment. For example, it may be fully or partially adhesive or fully or partially coated with adhesive material. The cover 200 may be united throughout its surface, i.e., the whole surface may be unbroken so that it has no holes.

In an embodiment, the cover 200 is symmetric with respect to a rotation of 180 degrees about an axis perpendicular to the longitudinal axis 210. The axis may additionally be perpendicular to the tangent of at least one of the first edge 202 and the second edge 204 at the intersection between said edge 202, 204 and the longitudinal axis 210. When the cover 200 is symmetric so that the either of the first edge 202 and the second edge 204 may function as a front edge, the ease of installation may be improved.

While the exact shape of the cover 200 may vary, the cover 200 has a cross section corresponding or substantially corresponding to a circular arc. The cross section is in a plane perpendicular to the longitudinal axis 210. The circular-arc cross section extends along the whole length of the cover. The cover 200 may be of substantially uniform thickness. The thickness of the cover may be, for example, 0.1-5 millimeters.

The cover 200 is adapted, e.g. shaped, for snap-on attachment to a cylindrical body, in particular to the connector 100. The snap-on attachment takes place at least in the two dimensions perpendicular to the longitudinal axis 210. This may mean, for example, that a detachment force exceeding a threshold detachment force is required to detach the cover 200. The snap-on attachment may therefore substantially prevent movement of the cover with respect to the connector 100 at least in the two dimensions perpendicular to the longitudinal axis 210. It may also prevent movement of the cover with respect to the connector 100 in the direction of the longitudinal axis 210. The snap-on attachment may be effected, for example, by gripping surfaces formed in the inner surface 212 for contact with the outer surface of the connector 100 and/or grip formed between the cover 200 and screw holes 120 in the connector 100 or holes 132 in the fasteners 130 in the connector 100. The cover 200 is made of flexible material to facilitate the snap-on attachment. For example, the cover may be made of plastic. Even when the cover 200 is flexible, it may still have a static shape to which it returns in the absence of bending forces exerted on the cover 200. Whereas it is evident that a strong enough force will break any physical object, the cover 200 may have a first threshold force below which the cover 200 will return to its static shape by itself. The first threshold force may be a breaking force or a permanent deformation force. The cover may be adapted to be used in the static shape. The cover may be of transparent or partially transparent material, which may aid in positioning the cover, particularly with respect to screw holes 120. The cover 200 may be adapted to be installed simply by pressing the cover 200 on top of the connector 100. In particular, the cover 200 is adapted for snap-on attachment by exerting a force, such as a pressing force, on the outer surface 214 of the cover 200 in a direction perpendicular to the longitudinal axis 210. The direction may additionally be perpendicular to the tangent of at least one of the first edge 202 and the second edge 204 at the intersection between said edge and the longitudinal axis 210. The cover 200 may be adapted for a second threshold force so that only a force exceeding the second threshold force attaches the cover 200. When the cover 200 additionally has a first threshold force, either or both of the pressing force and the second threshold force may be smaller than the first threshold force.

The length of the circular arc is more than 50 percent of the circumference of a full circle, i.e. the circular arc corresponds to an angle which is larger than 180 degrees or larger than pi in radians. For example, the length may be more than 51 percent or more than 55 percent of the circumference of a full circle. The length of the circular arc may also be less than 100 percent of the circumference of a full circle to facilitate easier installation. For example, the length of the circular arc may be any of the following: less than 95 percent, less than 85 percent, less than 75 percent, less than 65 percent or less than 55 percent of the circumference of a full circle. By lowering the percentage, material may be saved and ease of installation improved, whereas by increasing the percentage the gripping surface may be increased. The length of the circular arc may vary across the length of the cover 200 or it may be constant across the length of the cover 200. Any of the above values for the length of the circular arc may correspond to cross-sections along the whole length of the cover 200 or the length of the circular arc may be more than 50 percent of the circumference of a full circle only for a partial length of the cover 200, for example 20-100 percent of the length of the cover. The gripping surfaces created by the arc extending around the connector provide one way of realizing the snap-on attachment.

In an embodiment, the cover 200 comprises at least one recess (not visible in Fig. 2) extending from the inner surface 212 for alignment with at least one screw hole 120 in the connector 100. The recess may be circular or substantially circular. The depth of the recess may be, for example, 0.1-10 millimeters. The diameter of the recess may be at least that of a screw hole 120, for example 5-50 millimeters. The recess allows accommodating the ends of the fasteners 130 within the cover 200.

In an embodiment, the outer surface 214 is smooth. In another embodiment, the cover 200 comprises at least one bulge 220 extending from the outer surface 214 for alignment with at least one screw hole 120 in the connector 100. As the bulge creates a recess on the opposing side of the cover 200, i.e. on the inner surface 212, the bulge allows accommodating the ends of the fasteners 130 within the cover 200. In addition, as the cover 200 bulges outwards, a need to reduce the thickness of the cover 200 at the region of the cover 200 corresponding to the bulge 220 may be removed. For example, the thickness of the cover 200 may therefore be constant, in particular the thickness of the cover 200 may be constant between the region of the cover 200 adapted for alignment with the screw hole 120 and the region around the screw hole 120. The bulge 220 may be circular or substantially circular. The height of the bulge 220 may be, for example, 0.1-10 millimeters. The diameter of the bulge 220 may be at least that of a screw hole 120, for example 5-50 millimeters.

The number of recesses and/or bulges 220 may correspond to the number of screw holes 120 in the connector 100. For example, the number of recesses and/or bulges 220 may be from one to ten. For example, the number may be one for a cover adapted for a cable lug, or two or four for a cover adapted for a connector suitable for two cables.

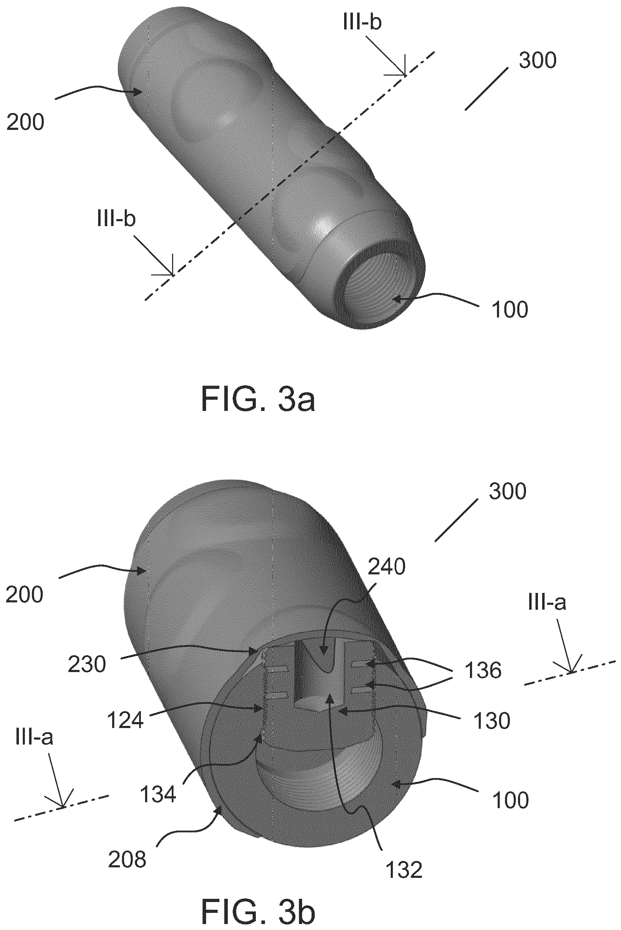

Fig. 3a illustrates an arrangement 300 comprising a connector 100 and a cover 200. The arrangement 300 may be constructed using any of the connectors 100 and covers 200 described herein. The cover 200 may be removably attachable to the connector 100 or it may be fixedly attached to the connector 100, for example along an edge or by an extension. Additional layers may be included in the arrangement 300 to form a connector arrangement. For example, the arrangement 300 may be covered by an insulating layer, for example by a silicone insulator. The cover 200 may then protect this additional layer from mechanical abrasion due to the fasteners 130.

Fig. 3b illustrates a cross-section of Fig. 3a in a plane perpendicular to a longitudinal axis of the cover 200. The connector 100 is shown with a fastener 130 installed in a screw hole 120 comprising threads 124. The fastener 130 comprises a hole 132 and threads 134. The fasteners 130 may be shearing screws or shearing bolts and they may comprise weakenings 136 such as breaking points 136. In the illustrated example, the end of the fastener 130 extends outside the connector 100.

The cover 200 has a cross section substantially corresponding to a circular arc 208. In the illustrated example, the cross section is circular along the length of the cover 200. In addition, the length of the arc remains substantially constant along the length of the cover 200. However, it is noted that alternative embodiments are also possible. For example, the cross section taken at all points along the length of the cover 200 may be circular or substantially circular while the length of the circular arcs 208 corresponding to the cross sections may vary along the length of the cover 200, for example between 10 and 95 percent of the circumference of a full circle. Correspondingly, the surface of the cover 200 may form one or more tooth- or fork-like gripping surfaces which may additionally be suitable for snap-on attachment to the connector 100.

The cover 200, according to the example illustrated in Fig. 3b, comprises a region of reduced thickness 230 for alignment with at least one edge of a screw hole 120 in the connector 100. The region 230 allows improving fitting of the cover 200 against the connector 100 even as the edges of the fastener 130 extend outwards from the outer surface of the connector 100. The region 230 may be line-shaped. In particular, the region 230 may be circular or ring-shaped to match the edge of a circular-ended fastener. The region 230 may be positioned within a bulge 220 extending outwards from the outer surface 214 of the cover 200.

The cover 200 may comprise at least one protrusion 240 extending from the inner surface 212 for engaging a screw hole 120 in the connector 100 or a hole 132 in a fastener 130 located in a screw hole 120 in the connector 100. The protrusion 240 is positioned to match the screw hole 120. It may be used to aid in positioning the cover 200 with respect to the connector 100. It may also be used for providing at least partial snap-on attachment. Yet in addition, the protrusion 240 may be used to prevent movement of the cover 200 with respect to the connector 100 at least in the direction of the longitudinal axis 210. The protrusion 240 may be of the same material as the cover 200. It may form a monolithic body with the cover 200 and it may have various shapes.

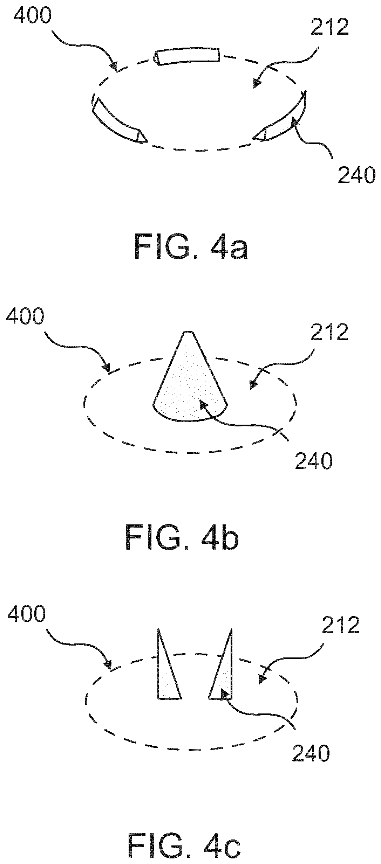

Figs. 4a-c illustrates various protrusions 240. The protrusions 240 may be arranged on the inner surface 212 of the cover 200 substantially on a line 400. The line 400 may be aligned with the edge 122 of a screw hole 120. The line 400 may be circular. There may be more than one protrusion 240 corresponding to a single screw hole 120. For example, a protrusion 240 may extend all the way along the length of the line 400 or it may be divided into two or more shorter portions, an example of which is illustrated in Fig. 4a. One or more protrusions 240 may also be located within a region enclosed by the line 400 for engaging holes 132 in fasteners 130, examples of which are illustrated in Figs. 4b and 4c. When there is more than one protrusion 240 corresponding to a single screw hole 120, the protrusions may be located both on the line 400 and within a region enclosed by the line 400. The protrusions 240 may be, for example, cone-, tooth-, tongue- or edge-shaped. The protrusions 240 may, for example, have height of 0.1-20 millimeters in the direction perpendicular to the inner surface 212. In an embodiment, at least one protrusion 240 is adapted to abut against an edge 122 of a screw hole 120 in the connector 100 or an edge of a hole 132 in a fastener 130 located in the screw hole 120.

In an embodiment, the cover 200 comprises or is made of material conducting electricity. The material may be fully conducting or semiconducting. The cover 200 may therefore be in the same electric potential as the connector 100, smoothening any peaks in the electric field in the region of the connector 100. In particular, the whole cover 200 may be fully conducting or semiconducting. In an embodiment, the cover 200 is made of semiconducting plastic.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from the present claims.

## Claims

1. An arrangement comprising a cover (200),
a cable connector (100) and a fastener (130)adapted for clamping a cable to the cable connector (100);
the cable connector (100) comprising a cylindrical body (110) having at least one screw hole (120) for the fastener (130),
the at least one screw hole (120)
extending transversely with respect to the longitudinal direction of the cylindrical body (110), the cable connector (100) being a cable lug or a connector comprising two or more inlets (112) for connecting cables to each other;
the cover (200) being made of a flexible material and comprising a first edge (202), a second edge (204), a longitudinal axis (210) extending between the first edge (202) and the second edge (204), an inner surface (212) for engaging the cable connector (100), and an outer surface (214) opposite to the inner surface (212);
**characterized in that**
the cover (200) has a cross section (208) substantially corresponding to a circular arc in a plane perpendicular to the longitudinal axis (210) and extending along the whole length of the cover (200);
the cover (200) is adapted for snap-on attachment to the cylindrical body (110) and the cover (200) is adapted for snap-on attachment by a force exerted on the outer surface (214) in a direction perpendicular to the longitudinal axis (210); and
the length of the circular arc is more than 50 percent of the circumference of a full circle allowing sides of the cover corresponding to the circular arc to effect the snap-on attachment.

2. The arrangement according to any of the preceding claims wherein the length of the circular arc is less than 95 percent of the circumference of a full circle.

3. The arrangement according to any of the preceding claims, wherein the cover (200) comprises at least one region (230) of reduced thickness for alignment with at least one edge of the screw hole (120) in the cable connector (100).

4. The arrangement according to claim 3 wherein the at least one region (230) of reduced thickness is ring-shaped.

5. The arrangement according to any of the preceding claims, wherein the cover (200) comprises at least one recess extending from the inner surface (212) for alignment with at least one screw hole (120) in the cable connector (100).

6. The arrangement according to any of the preceding claims, wherein the cover (200) comprises at least one bulge (220) extending from the outer surface (214) for alignment with at least one screw hole (120) in the cable connector (100).

7. The arrangement according to any of the preceding claims, wherein the cover (200) comprises at least one protrusion (240) extending from the inner surface (212) for engaging the screw hole (120) in the cable connector (100) or a hole (132) in a fastener (130) located in the screw hole (120) in the cable connector (100).

8. The arrangement according to claim 7, wherein the at least one protrusion (240) is adapted to abut against an edge (122) of the screw hole (120) or an edge of a hole (132) in a fastener (130) located in the screw hole (120).

9. The arrangement according to any of the preceding claims wherein the cover (200) comprises or is made of material conducting electricity.

10. The arrangement according to any of the preceding claims wherein the cover (200) is semiconducting.

11. The arrangement according to claim 10, wherein the cover (200) is of semiconducting plastic.

12. The arrangement according to any of the preceding claims wherein the cover (200) is symmetric with respect to a rotation of 180 degrees about an axis perpendicular to the longitudinal axis (210).

## Patentansprüche

1. Anordnung mit einer Abdeckung (200), einem Kabelverbinder (100) und einem Befestigungselement (130), das zum Festklemmen eines Kabels an dem Kabelverbinder (100) ausgelegt ist;
wobei der Kabelverbinder (100) einen zylindrischen Körper (110) mit mindestens einem Schraubenloch (120) für das Befestigungselement (130) aufweist, wobei sich das mindestens eine Schraubenloch (120) quer in Bezug auf die Längsrichtung des zylindrischen Körpers (110) erstreckt, wobei der Kabelverbinder (100) eine Kabelöse oder ein Verbinder mit zwei oder mehr Einlässen (112) zum Verbinden von Kabeln miteinander ist;
wobei die Abdeckung (200) aus einem flexiblen Material hergestellt ist und eine erste Kante (202), eine zweite Kante (204), eine Längsachse (210), die sich zwischen der ersten Kante (202) und der zweiten Kante (204) erstreckt, eine Innenfläche (212) zum Eingriff mit dem Kabelverbinder (100) und eine Außenfläche (214) gegenüber der Innenfläche (212) aufweist;
**dadurch gekennzeichnet, dass**
die Abdeckung (200) einen Querschnitt (208) aufweist, der im Wesentlichen einem Kreisbogen in einer Ebene senkrecht zu der Längsachse (210) entspricht und sich entlang der gesamten Länge der Abdeckung (200) erstreckt;
die Abdeckung (200) zur Schnappbefestigung an dem zylindrischen Körper (110) ausgelegt ist und die Abdeckung (200) zur Schnappbefestigung durch eine Kraft ausgelegt ist, die auf die Außenfläche (214) in einer Richtung senkrecht zu der Längsachse (210) ausgeübt wird; und
die Länge des Kreisbogens mehr als 50 Prozent des Umfangs eines Vollkreises beträgt, so dass Seiten der Abdeckung, die dem Kreisbogen entsprechen, die Schnappbefestigung bewirken können.

2. Anordnung nach einem der vorhergehenden Ansprüche, wobei die Länge des Kreisbogens weniger als 95 Prozent des Umfangs eines Vollkreises beträgt.

3. Anordnung nach einem der vorhergehenden Ansprüche, wobei die Abdeckung (200) mindestens einen Bereich (230) reduzierter Dicke zur Ausrichtung mit mindestens einer Kante des Schraubenlochs (120) in dem Kabelverbinder (100) umfasst.

4. Anordnung nach Anspruch 3, wobei der mindestens eine Bereich (230) reduzierter Dicke ringförmig ist.

5. Anordnung nach einem der vorhergehenden Ansprüche, wobei die Abdeckung (200) mindestens eine Aussparung umfasst, die sich von der Innenfläche (212) zur Ausrichtung mit mindestens einem Schraubenloch (120) in dem Kabelverbinder (100) erstreckt.

6. Anordnung nach einem der vorhergehenden Ansprüche, wobei die Abdeckung (200) mindestens eine Ausbuchtung (220) umfasst, die sich von der Außenfläche (214) zur Ausrichtung mit mindestens einem Schraubenloch (120) in dem Kabelverbinder (100) erstreckt.

7. Anordnung nach einem der vorhergehenden Ansprüche, wobei die Abdeckung (200) mindestens einen Vorsprung (240) umfasst, der sich von der Innenfläche (212) zum Eingriff mit dem Schraubenloch (120) in dem Kabelverbinder (100) oder einem Loch (132) in einem Befestigungselement (130), das sich in dem Schraubenloch (120) in dem Kabelverbinder (100) befindet, erstreckt.

8. Anordnung nach Anspruch 7, wobei der mindestens eine Vorsprung (240) dazu ausgelegt ist, an einer Kante (122) des Schraubenlochs (120) oder einer Kante eines Lochs (132) in einem Befestigungselement (130), das sich in dem Schraubenloch (120) befindet, anzuliegen.

9. Anordnung nach einem der vorhergehenden Ansprüche, wobei die Abdeckung (200) ein Strom leitendes Material umfasst oder daraus besteht.

10. Anordnung nach einem der vorhergehenden Ansprüche, wobei die Abdeckung (200) halbleitend ist.

11. Anordnung nach Anspruch 10, wobei die Abdeckung (200) aus halbleitendem Kunststoff besteht.

12. Anordnung nach einem der vorhergehenden Ansprüche, wobei die Abdeckung (200) in Bezug auf eine Drehung von 180 Grad um eine Achse senkrecht zu der Längsachse (210) symmetrisch ist.

## Revendications

1. Dispositif comprenant un couvercle (200), un connecteur de câble (100) et une attache (130) adaptée pour serrer un câble au connecteur de câble (100) ;
le connecteur de câble (100) comprenant un corps cylindrique (110) présentant au moins un trou de vis (120) pour l'attache (130), le au moins un trou de vis (120) s'étendant transversalement par rapport à la direction longitudinale du corps cylindrique (110), le connecteur de câble (100) étant une cosse ou un connecteur de câble comprenant deux entrées (112) ou plus pour connecter des câbles les uns aux autres ;
le couvercle (200) étant fabriqué dans un matériau souple et comprenant un premier bord (202), un second bord (204), un axe longitudinal (210) s'étendant entre le premier bord (202) et le second bord (204), une surface intérieure (212) pour venir en prise avec le connecteur de câble (100), et une surface extérieure (214) opposée à la surface intérieure (212) ;
**caractérisé en ce que**
le couvercle (200) présente une section transversale (208) correspondant substantiellement à un arc circulaire dans un plan perpendiculaire à l'axe longitudinal (210) et s'étendant le long de la longueur entière du couvercle (200) ;
le couvercle (200) est adapté pour une fixation encliquetable au corps cylindrique (110) et le couvercle (200) est adapté pour une fixation encliquetable par une force exercée sur la surface extérieure (214) dans une direction perpendiculaire à l'axe longitudinal (210) ; et
la longueur de l'arc circulaire est supérieure à 50 % de la circonférence d'un cercle complet permettant à des côtés du couvercle correspondant à l'arc circulaire d'effectuer la fixation encliquetable.

2. Dispositif selon l'une quelconque des revendications précédentes, dans lequel la longueur de l'arc circulaire est inférieure à 95 % de la circonférence d'un cercle complet.

3. Dispositif selon l'une quelconque des revendications précédentes, dans lequel le couvercle (200) comprend au moins une région (230) d'épaisseur réduite pour un alignement avec au moins un bord du trou de vis (120) dans le connecteur de câble (100).

4. Dispositif selon la revendication 3, dans lequel la au moins une région (230) d'épaisseur réduite est en forme d'anneau.

5. Dispositif selon l'une quelconque des revendications précédentes, dans lequel le couvercle (200) comprend au moins un évidement s'étendant à partir de la surface intérieure (212) pour un alignement avec au moins un trou de vis (120) dans le connecteur de câble (100).

6. Dispositif selon l'une quelconque des revendications précédentes, dans lequel le couvercle (200) comprend au moins un renflement (220) s'étendant à partir de la surface extérieure (214) pour un alignement avec au moins un trou de vis (120) dans le connecteur de câble (100).

7. Dispositif selon l'une quelconque des revendications précédentes, dans lequel le couvercle (200) comprend au moins une saillie (240) s'étendant à partir de la surface intérieure (212) pour venir en prise avec le trou de vis (120) dans le connecteur de câble (100) ou un trou (132) dans une attache (130) située dans le trou de vis (120) dans le connecteur de câble (100).

8. Dispositif selon la revendication 7, dans lequel la au moins une saillie (240) est adaptée pour venir en butée contre un bord (122) du trou de vis (120) ou un bord d'un trou (132) dans une attache (130) située dans le trou de vis (120).

9. Dispositif selon l'une quelconque des revendications précédentes, dans lequel le couvercle (200) comprend ou est fabriqué dans un matériau conduisant l'électricité.

10. Dispositif selon l'une quelconque des revendications précédentes, dans lequel le couvercle (200) est semi-conducteur.

11. Dispositif selon la revendication 10, dans lequel le couvercle (200) est fabriqué en un plastique semi-conducteur.

12. Dispositif selon l'une quelconque des revendications précédentes, dans lequel le couvercle (200) est symétrique par rapport à une rotation de 180 degrés autour d'un axe perpendiculaire à l'axe longitudinal (210).
